Europäisches Patentamt

**European Patent Office**

**Office européen des brevets**

(19)

(11) Publication number: **0 246 682**

**A1**

(12)

# EUROPEAN PATENT APPLICATION

(21) Application number: **87200711.7**

(22) Date of filing: **15.04.87**

(51) Int. Cl.³: **H 01 L 21/00**
**H 01 L 21/60, H 01 L 21/285**
**H 01 L 21/76**

(30) Priority: **23.04.86 NL 8601039**
**23.04.86 NL 8601040**
**03.11.86 NL 8602772**

(43) Date of publication of application:
**25.11.87 Bulletin 87/48**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Maas, Henricus Godefridus Rafael**
**c/o INT. OCTROOIBUREAU B.V. Prof. Holstlaan 6**
**NL-5656 AA Eindhoven(NL)**

(72) Inventor: **Van der Velden, Johannes Wilhelmus Adrianus**
**c/o INT. OCTROOIBUREAU B.V. Prof. Holstlaan 6**
**NL-5656 AA Eindhoven(NL)**

(72) Inventor: **Davids, Geert Jan Thomas**
**c/o INT. OCTROOIBUREAU B.V. Prof. Holstlaan 6**
**NL-5656 AA Eindhoven(NL)**

(72) Inventor: **Van Es, Ronald Arthur**
**c/o INT. OCTROOIBUREAU B.V. Prof. Holstlaan 6**
**NL-5656 AA Eindhoven(NL)**

(72) Inventor: **Esser, Leonard Jan Maria**
**c/o INT. OCTROOIBUREAU B.V. Prof. Holstlaan 6**
**NL-5656 AA Eindhoven(NL)**

(72) Inventor: **Noorslag, Date Jan Willem**
**c/o INT. OCTROOIBUREAU B.V. Prof. Holstlaan 6**
**NL-5656 AA Eindhoven(NL)**

(72) Inventor: **Osinski, Kazimierz**
**c/o INT. OCTROOIBUREAU B.V. Prof. Holstlaan 6**
**NL-5656 AA Eindhoven(NL)**

(72) Inventor: **Slotboom, Jan Willem**
**c/o INT. OCTROOIBUREAU B.V. Prof. Holstlaan 6**
**NL-5656 AA Eindhoven(NL)**

(72) Inventor: **Ulenaers, Mathieu Joseph Emanuel**
**c/o INT. OCTROOIBUREAU B.V. Prof. Holstlaan 6**
**NL-5656 AA Eindhoven(NL)**

(74) Representative: **Veerman, Jan Willem et al,**
**INTERNATIONAAL OCTROOIBUREAU B.V. Prof.**
**Holstlaan 6**
**NL-5656 AA Eindhoven(NL)**

(54) Method of manufacturing a semiconductor device comprising an electrode made of polycrystalline silicon, and device manufactured by that method.

(57) The invention relates to a method of manufacturing for the major part in a self-aligned manner a semiconductor circuit, in which an oxidation-preventing layer (2) and a masking layer are successively provided on the surface of a substrate region (1) of silicon.

According to the invention, the masking layer comprises a layer of a first material (3), along which an edge portion (5) of a second material is formed, which is selectively etchable with respect to the first material and the oxidation-preventing layer (2).

./...

After the uncovered part of the oxidation-preventing layer has been removed, an insulation region (8) surrounding an island-shaped part (9a) of the substrate region is formed in the exposed part of the substrate region (1). When the edge portion (5) formed from the second material and the underlying part of the oxidation-preventing layer (2) are etched selectively, an electrode region (33) is defined, on which an electrode is formed by a polycrystalline silicon layer (16). Subsequently, in a self-aligned manner at least one zone (20, 22) of a semiconductor element is formed in the island-shaped part (9a).

The invention is of major importance for the manufacture of monolithic integrated circuits having a high packing density, by means of conventional lithography and further relates to a semiconductor device manufactured by the use of the method.

FIG.10

Method of manufacturing a semiconductor device and device
manufactured by means of the method.

The invention relates to a method of manufacturing
a semiconductor device, in which an oxidation-preventing
layer is provided on the surface of a substrate region
of silicon and a masking layer is provided on this layer,
after which the unmasked part of the oxidation-preventing
layer is removed and an insulation region consisting at
least in part of silicon oxide is formed in the exposed
part of the substrate region, this insulation region
surrounding an island-shaped part of the substrate region
in which at least one zone of a semiconductor element is
formed, and an electrode constituted by a polycrystalline
silicon layer is formed on an electrode region of the
semiconductor element.

The invention further relates to a device
manufactured by means of the method according to the
invention.

A method of the kind mentioned in the opening
paragraph is known from US Publication: "Extended Abstracts
of the 16th Conference on Solid State Devices and Materials"
1984, p. 210-211. In this case, the surface of a silicon
substrate is covered by an oxidation-preventing layer,
which is patterned by masking and subsequent etching in
such a manner that the silicon substrate is covered by
this layer only at the area of an island-shaped region
to be formed. The part of the silicon substrate not covered
by the oxidation-preventing layer is then thermally
oxidized so that an insulation region of silicon oxide
is obtained, which surrounds an island-shaped part of the
substrate. Subsequently, the assembly is covered in order
of succession by a silicon oxide layer, a silicon nitride
layer and a polycrystalline silicon layer. The polycrystalline silicon layer is removed by means of a mask and by
etching at the area of the active semiconductor zones to be formed in the island-shaped region and is then oxidized.
The now uncovered parts of the underlying silicon nitride
layer and the silicon oxide layer are removed by isotropic
etching, like an adjoining circular part of the part of
the silicon nitride layer covered by the polycrystalline
silicon layer and the underlying silicon oxide layer.
The cavities formed by this "under-etching" are then
filled with polycrystalline silicon in order to obtain
the contact between the polycrystalline silicon layer
and the electrode region of the semiconductor element.
Subsequently, a base zone and an emitter zone are implanted
in a conventional manner with the use of the oxidized
polycrystalline silicon layer as a mask.

In the known method described above, a mask is
used both for the definition of the island-shaped region
and for the definition of the active semiconductor zones
within this island-shaped region. These masks should be
aligned to each other very accurately within fairly
critical tolerances. This requires space, which with the
very small dimensions can occupy a considerable part of the
overall surface area of the circuit especially in very
large scale integrated circuits.

The invention has _inter alia_ for its object
to define by the use of only one mask both the said
insulation region and most of the zones of the semiconductor
element to be formed within the island-shaped part of the
substrate region surrounded by the insulation region, as
a result of which an alignment step, which in the known
method is inevitable, is avoided.

For this purpose, according to the invention,
a method of the kind mentioned in the opening paragraph
is characterized in that, in order to form the said masking
layer, a part of the oxidation-preventing layer is covered
by a layer of a first material, which is then patterned
and along which, without the use of a mask, an edge portion
of a second material is formed, which can be etched
selectively with respect to the first material and the
oxidation-preventing layer, in that then the uncovered part of the oxidation-preventing layer is removed, in that subsequently the insulation region is formed at least in part in the exposed part of the substrate region, and in that the electrode region is defined by selectively etching the edge portion formed from the second material and the underlying part of the oxidation-preventing layer.

The invention is based _inter alia_ on the recognition of the fact that, after the island-shaped region has been defined by means of a mask, the electrode regions and zones of the semiconductor element can be realized substantially entirely in a self-aligned manner by successive selective etching steps and oxidation steps.

By means of the method according to the invention, the structure of semiconductor elements of different types can be defined in a self-aligned manner and for a considerable part by means of only one mask.

A preferred embodiment of the method according to the invention is characterized in that of the first and of the second material one is silicon and the other is silicon oxide. Thus, it is possible to etch the edge portion of the second material selectively with respect to the layer of the first material.

A particular embodiment of the method according to the invention is characterized in that the first material is silicon oxide and the second material is silicon. In order to form the edge portion, it is to be preferred that, after the silicon oxide layer has been provided, the assembly is covered by a layer of silicon, which is then etched back anisotropically until only the said edge portion is left.

Such a back-etching step can be avoided, however, if the first material is silicon and the second material is silicon oxide, the said edge portion being formed by thermal oxidation of the layer of the first material.

According to a particular preferred embodiment, after the said edge portion has been formed and the uncovered part of the oxidation-preventing layer has then been removed, the exposed silicon is etched before the insulation region formed.

In a further preferred embodiment, a groove is etched in the exposed silicon, after which the bottom and the walls of the groove are preferably provided with a silicon oxide layer, after which the groove is filled with polycrystalline silicon.

The invention will be described more fully with reference to a number of embodiments and the drawing, in which:

Figures 1 to 8 show diagrammatically in sectional view a semiconductor device at successive stages of manufacture by means of the method according to the invention;

Figures 9 and 10 show diagrammatically a variation of the method according to the invention;

Figures 11 to 12C show diagrammatically in sectional view a MOS transistor at successive stages of the manufacture by means of the method according to the invention;

Figures 13 to 26 show diagrammatically in sectional view another semiconductor device at successive stages of manufacture by means of the method according to the invention;

Figures 27 to 29 show in plan view and diagrammatically in cross-section another device manufactured by means of the method according to the invention;

Figures 30 to 32 show in plan view and diagrammatically in cross-section a further device manufactured by the use of the invention;

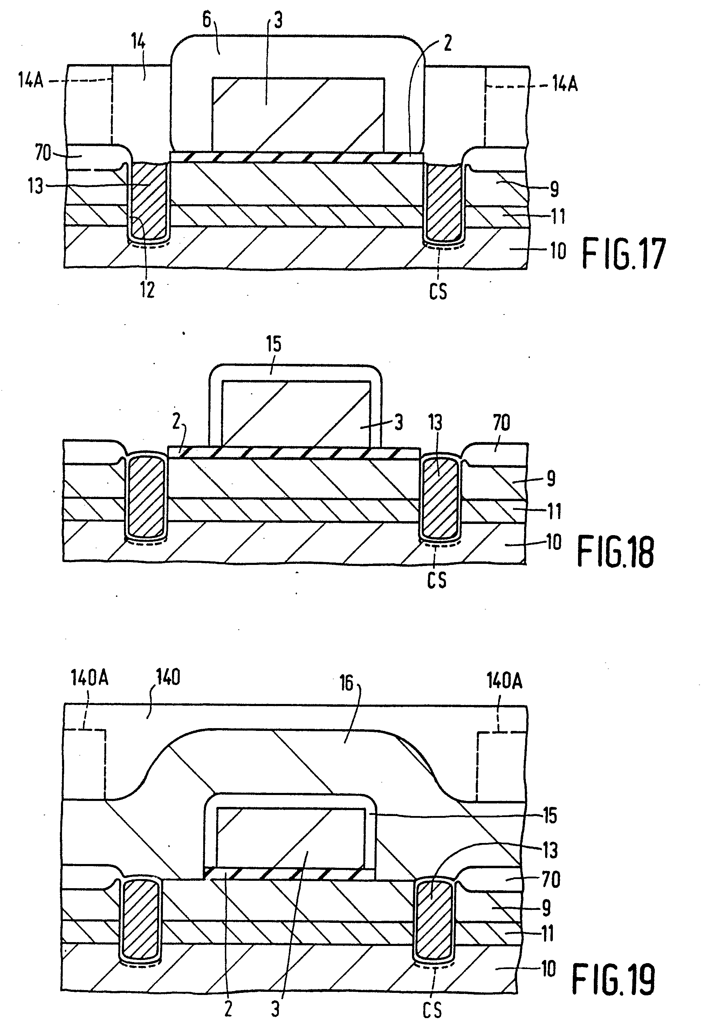

Figs. 18A to 21A, Figures 33 and 34 show variations of the method according to the invention;

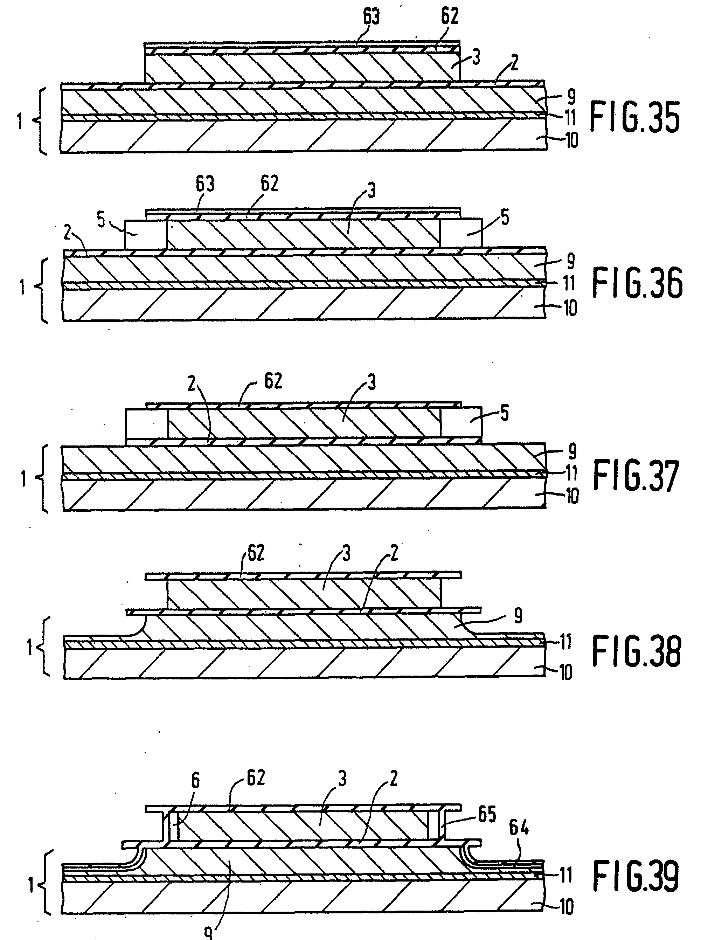

Figures 35 to 44 show diagrammatically in cross-section another semiconductor device at successive stages of manufacture according to the invention;

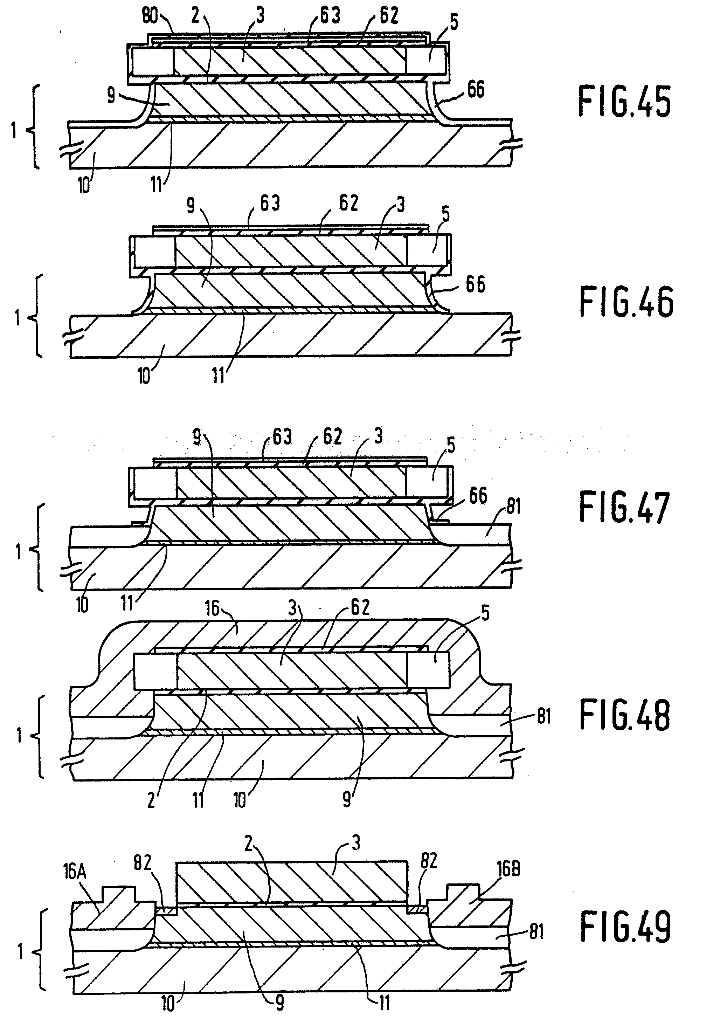

Figures 45 to 50 show successive stages of manufacture according to a variation of the method in accordance with the invention;

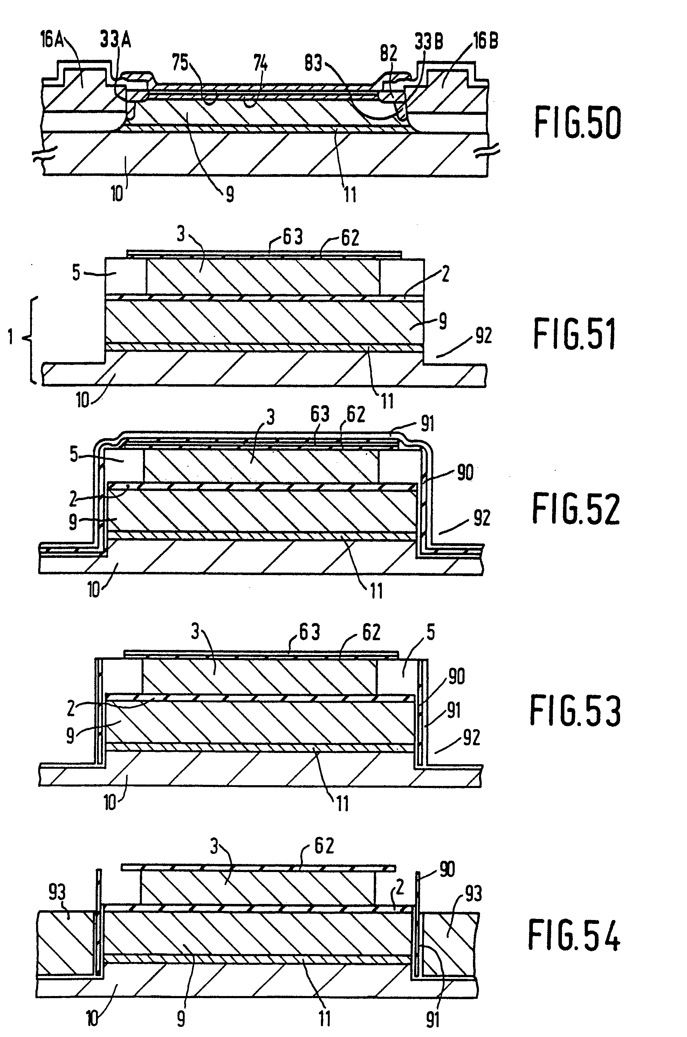

Figures 51 to 59 show successive stages of a further variation of the method according to the invention, and

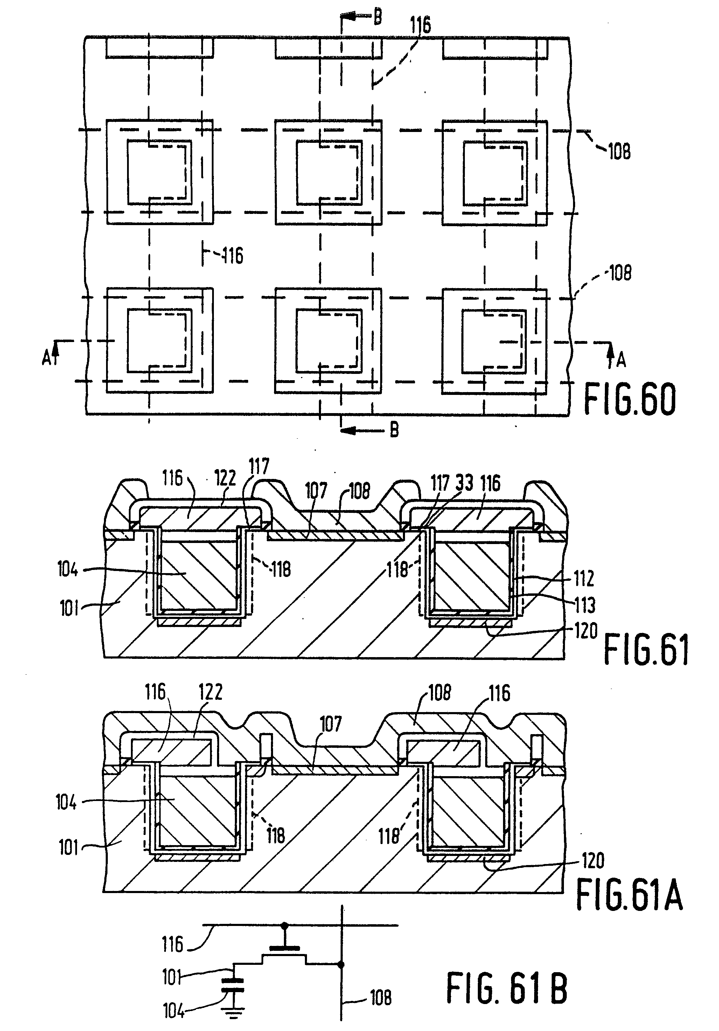

Figures 60 to 69 show the manufacture of a memory comprising DRAM cells according to the invention. The Figures are schematic and are not drawn to scale. For the sake of clarity, especially certain dimensions are greatly exaggerated. Corresponding parts are generally designated by the same reference numerals. Semiconductor zones of the same conductivety type are cross-hatched in the cross-sections generally in the same direction.

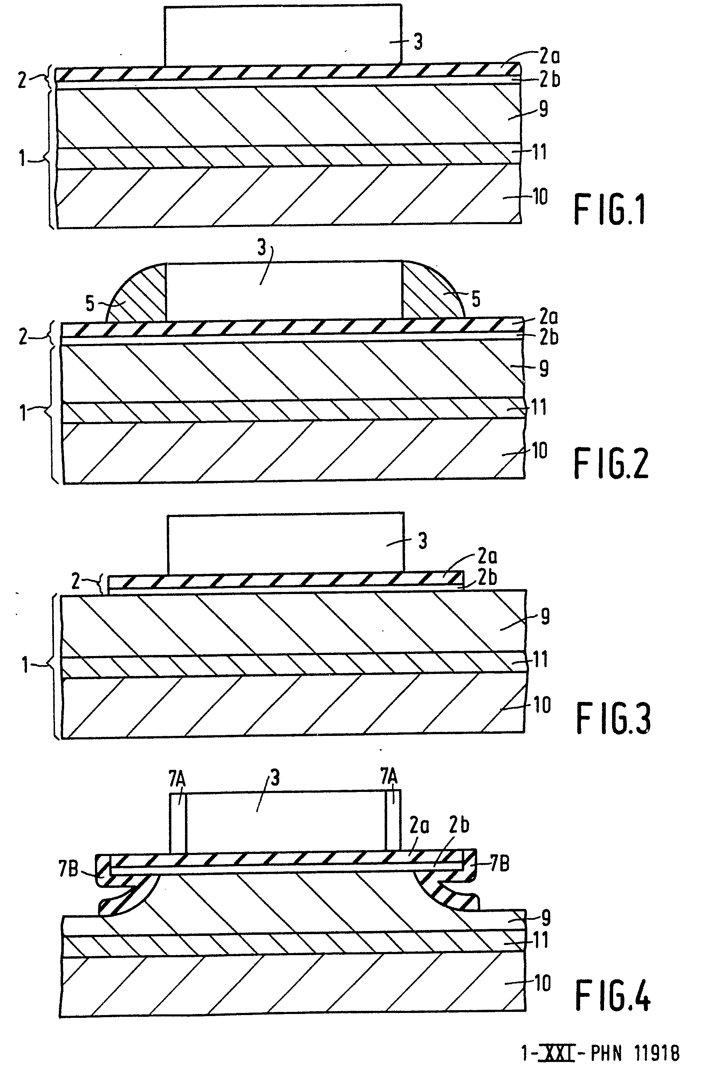

The starting material (cf. Fig. 1) is a substrate region 1 of silicon, which consists in this embodiment of a p-type substrate 10, an n-type epitaxial layer 9 disposed on it and a highly doped n-type buried layer 11. In a first processing step, an oxidation-preventing layer 2 and a masking layer are successively provided on the substrate region 1 on the surface of the epitaxial layer 9. In this embodiment, the oxidation-preventing layer consists of a silicon nitride layer 2a having a thickness of about 100 nm and an underlying layer 2b of silicon oxide or silicon oxynitride having a thickness of about 40 nm. The masking layer in this embodiment comprises a silicon oxide layer having an edge portion of silicon.

In order to provide this masking layer, the oxidation-preventing layer 2 is first covered by a silicon oxide layer 3 having a thickness of about 1.4 μm. This layer may be deposited, for example, in a usual manner from the gaseous phase by decomposition of tetraethyl orthosilicate. By masking and etching, the silicon oxide layer 3 is patterned, the silicon oxide being maintained at the area at which at a later stage at least one zone of the semiconductor element is formed (cf. Fig. 1). The assembly is then covered by a layer of polycrystalline silicon having a thickness of about 0.7 μm, which is then etched back anisotropically in such a manner that an edge portion 5 is maintained only along the silicon oxide layer 3 (cf. Fig. 2). The edge portion 5 is formed entirely in a self-aligned manner, that is to say without the use of a mask, along the silicon oxide layer 3. It should be noted that, when in this Application the term "polycrystalline silicon" is used, it is to be understood to include all forms of non-monocrystalline silicon, i.e. also for example amorphous silicon. Subsequently, the uncovered part of the silicon nitride layer 2a, the edge portion 5 and the uncovered part of the silicon oxide or silicon oxynitride layer 2b are successively etched away. The edge portion 5 of polycrystalline silicon may be etched away, for example, with a KOH solution selectively with respect to the silicon oxide layer 3 and the silicon nitride layer 2a. Thus, the situation of Fig. 3 is obtained.

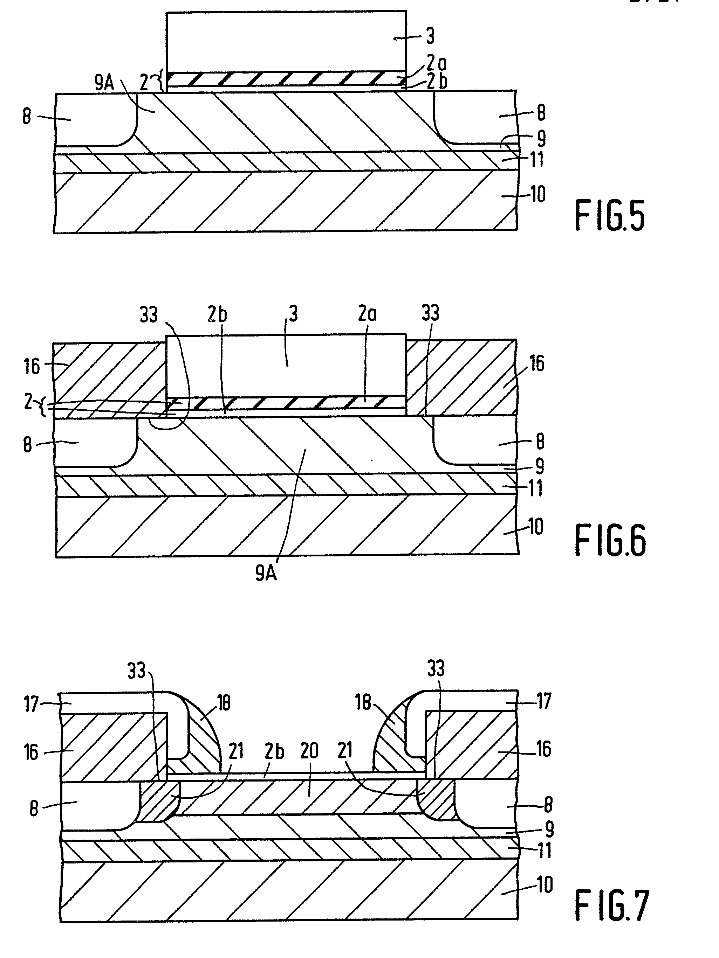

In this embodiment, the exposed part of the substrate region 1 is then partly etched away, as a result of which a mesa structure is obtained, after which the assembly is covered by a second oxidation-preventing layer 7, which is then etched away anisotropically so that only the vertical parts 7a thereof and the parts 7b screened by the oxidation-preventing layer 2 are maintained (cf. Fig. 4). Again the second oxidation-preventing layer 7 may be a silicon nitride layer, as the case may be with an underlying layer of silicon oxide.

By thermal oxidation at a temperature of about $1000^{o}C$ in an atmosphere of steam, an island insulation region in the form of a sunken silicon oxide pattern 8 is formed in the exposed part of the substrate region, this island insulation region surrounding an island-shaped region 9A, after which all the exposed parts of the oxidation-preventing layers (2 and 7) are etched away so that the situation of Fig. 5 is obtained. It should be noted that the steps of providing and then anisotropically etching back the second oxidation-preventing layer 7 are effected only in order to obtain a flat structure of the insulation region 8, but are not essential as such to the invention.

An electrode is now formed on an electrode region 33 (cf. Fig. 6) of the semiconductor element from a polycrystalline silicon layer. For this purpose, the assembly is covered by a polycrystalline silicon layer 16 having a thickness of about 0.5 µm, which is then etched away from the upper side of the silicon oxide layer 3. This may be effected, for example, by planarization, the polycrystalline silicon layer 16 being covered by a photoresist layer, which is then subjected together with the silicon layer 16 to a dry back-etching step to such an extent that the silicon oxide layer 3 is just exposed (cf. Fig. 6). Subsequently, any remainder of the photoresist layer is removed. An implantation with boron ions is then carried out, as a result of which the polycrystalline silicon layer 16 becomes p-type conducting. In this embodiment, the ion concentration in the doped silicon layer 16 is about $10^{20}$ ions per $cm^3$. Subsequently, the silicon oxide layer 3 is etched away, after which an implantation with boron ions is carried out to obtain in the epitaxial layer 9 a base zone 20 having a concentration of about $10^{17}$ boron ions per $cm^3$. By thermal oxidation, an about 0.2 $\mu m$ thick silicon oxide layer 17 is now formed on the exposed part of the polycrystalline silicon layer 16. Highly doped p-type base contact zones 21 are then formed by diffusion of boron ions from the polycrystalline silicon layer 16 into the epitaxial layer 9. It should be noted that a higher doping of the base contact zone 21 can be obtained if, before the polycrystalline silicon layer 16 is provided, an implantation with boron ions is carried out. Subsequently, a strip of a dielectric material, in this embodiment silicon nitride, is formed along the edge of the oxidized polycrystalline silicon layer. For this purpose, an about 0.1-0.3 $\mu m$ thick silicon nitride layer is provided on the assembly and is then etched back anisotropically together with the underlying silicon nitride layer 2a in such a manner that only a strip 18 is left (cf. Fig. 7).

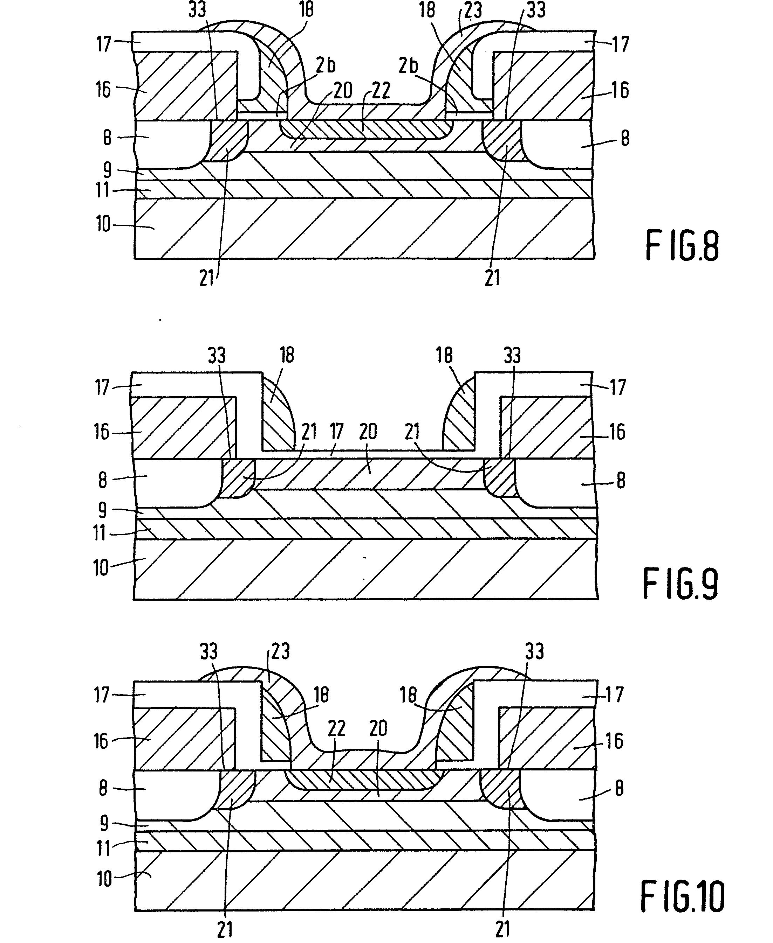

Now an implantation with arsenic ions is carried out, as a result of which an emitter zone 22 having a concentration of about $10^{20}$ arsenic ions per $cm^3$ is obtained. The polycrystalline silicon layer 16, the silicon oxide layer 17 and the nitride strip 18 together mask against the implantation. It should be noted that, where in this application the term "nitride" is used, it is to be understood to mean silicon nitride, while, where the term "oxide" is used, it is to be understood to mean silicon oxide, unless otherwise stated. After an emitter contact window has been formed by etching without a mask (dip etching), an emitter contact metallization 23 is provided (cf. Fig. 8).

It should be noted that, after the situation of Fig. 6 has been obtained, the procedure may also be as follows:

After the polycrystalline silicon layer 16 has been doped with boron ions, the silicon oxide layer 3 and the underlying oxidation-preventing layer 2 are successively removed by etching. By thermal oxidation, a layer of silicon oxide 17 is now formed on the exposed silicon (cf. Fig. 9). This layer is thicker on the highly doped p-type polycrystalline silicon layer 16 than on the monocrystalline epitaxial layer 9 due to the difference in oxidation rate between these two layers. During the thermal oxidation, highly doped p-type contact zones 21 are formed by diffusion of boron ions from the polycrystalline silicon layer 16. Subsequently, a base zone 20 having a concentration of about $10^{17}$ boron ions per $cm^3$ is implanted with boron ions in the epitaxial layer 9. The assembly is now covered by an about 0.3 μm thick silicon nitride layer, which is then etched back anisotropically in such a manner that only a strip 18 is left (cf. Fig. 9). Both in this embodiment of the invention and in the preceding embodiment, it is ensured by means of the nitride strip 18 that the contact zones 21 do not touch the emitter zone 22 to be formed, which would adversely affect the properties of the emitter-base junction.

After the nitride strip 18 has been formed, the etching and metallization steps of Fig. 8 are carried out so that the configuration of Fig. 10 is obtained. It should be noted that, when an emitter contact window

0246682
4-12-1986

17 is formed in the silicon oxide layer 16 by dip etching, the part of this layer on the polycrystalline silicon layer 16 is maintained for the major part due to the considerably larger thickness of this part of the silicon oxide layer 17 with respect to the part in which the contact window is etched. Thus, it is achieved that with the use of only one mask, i.e. for patterning the silicon oxide layer 3, the whole structure of a bipolar transistor is composed in a self-aligned manner.

The method according to the invention can be of importance not only for the manufacture of bipolar transistors, but also for the manufacture of other semiconductor circuit elements, for example for the manufacture of MOS transistors (in which event the regions 21 can form the source and drain zones).

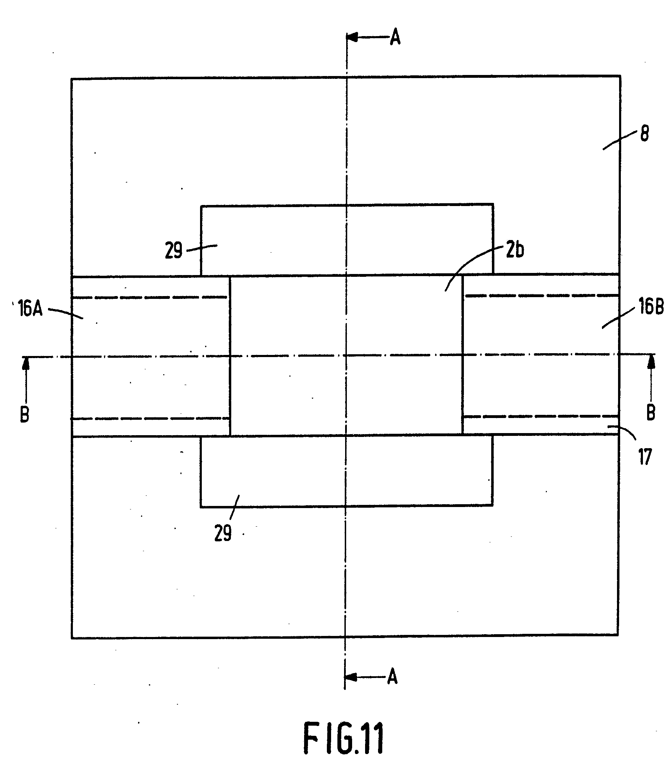

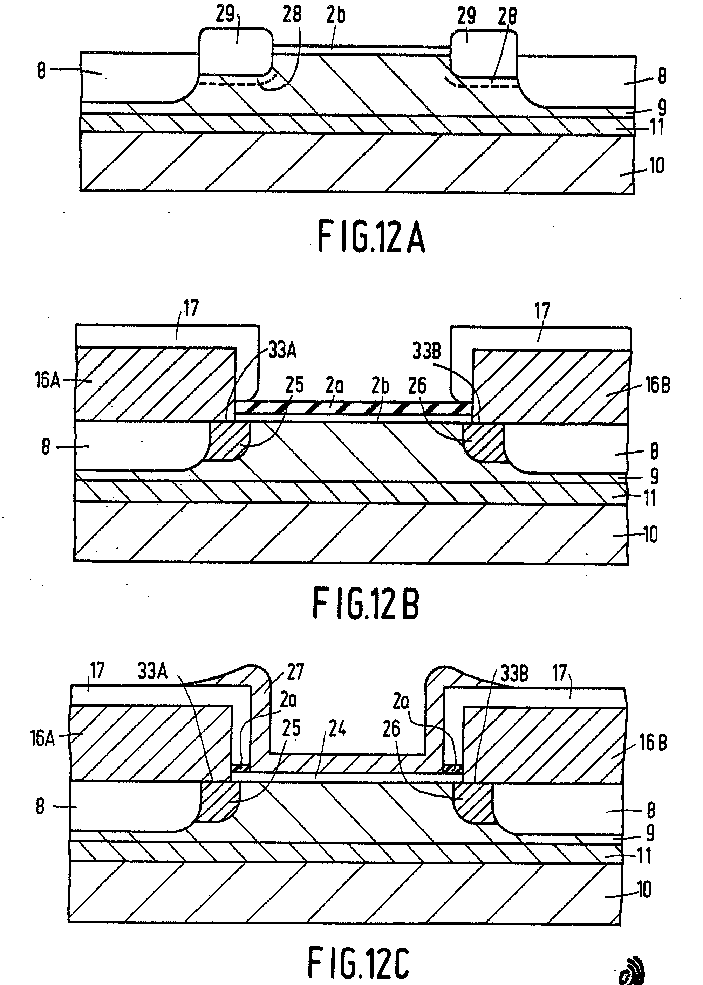

In Figures 11 to 12C, starting from the configuration of Fig. 6, different stages of the manufacture of a MOS transistor are shown by way of example. Fig. 12A shows along the line A-A of Fig. 11 and Fig. 12B shows along the line B-B an intermediate stage, while Fig. 12C shows a final stage along the line B-B in cross section.

First the silicon oxide layer 3 is etched away. Subsequently, an etching mask is provided on the assembly, after which the uncovered parts of the polycrystalline silicon layer 16 are etched away so that, as shown in Fig. 11 in plan view in dotted lines, two connection electrodes 16A and 16B are formed therefrom on electrode regions 33A and 33B. Also the exposed area of the nitride layer 2a is etched away. A highly doped channel stopper zone 28 of the same conductivity type as the epitaxial layer 9 is now implanted in the exposed part of the epitaxial layer 9 (cf. Fig. 12A). The etching mask then serves as an implantation mask. After the etching mask has been removed, a silicon oxide layer 17 is formed on the connection electrodes 16A, 16B and a partly sunken silicon oxide region 29 is formed in the exposed part of the epitaxial layer 9 by thermal oxidation (cf. Figures 12A and 12B). A highly doped p-type source zone 25 and drain zone 26 are also

0246682
4-12-1986

formed in the epitaxial layer 9 by diffusion of an impurity from the connection electrodes 16A and 16B. Subsequently, the remainder of the nitride layer 2a and of the silicon oxide layer 2b are etched away, after which a gate oxide 24 is formed on the exposed part of the epitaxial layer 9. In a given case, this gate oxide may be constituted by the silicon oxide layer 2b of the oxidation-preventing layer 2. Finally, a control electrode 27 consisting of a layer of metal, metal silicide or silicon is provided on the gate oxide 24 so that the final stage of Fig. 12C is obtained.

Although the described manufacture of a MOS transistor requires an additional mask, the alignment of this mask is not very critical so that this is not objectionable.

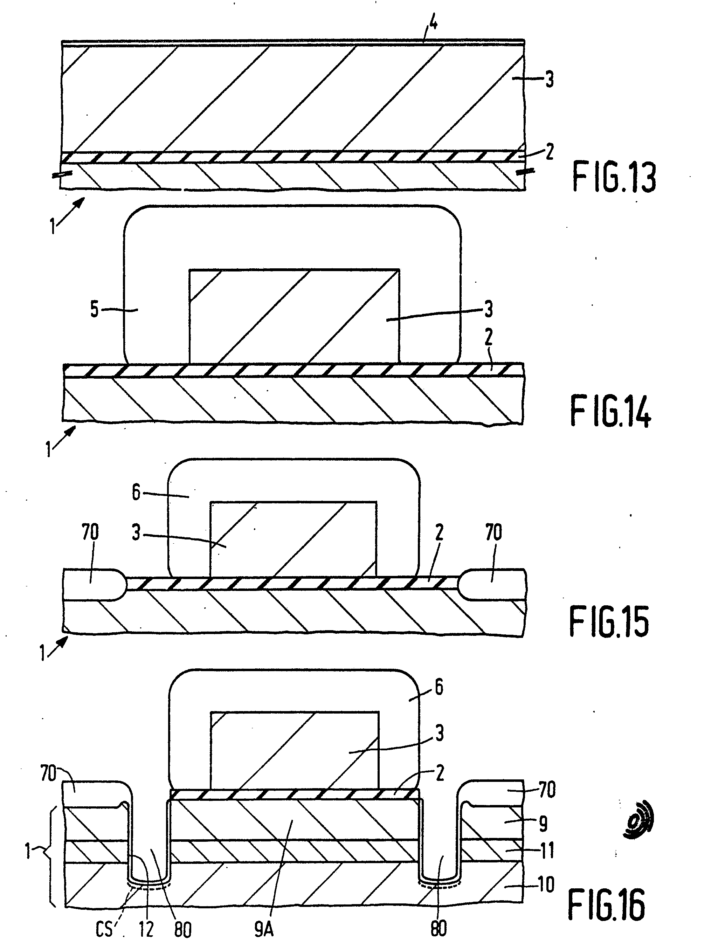

Fig. 13 shows diagrammatically in cross-section a first stage of manufacture of another semiconductor device by means of the method according to the invention. An oxidation-preventing layer 2 and a masking layer are successively provided on a substrate region 1 of silicon. The layer 2 preferably consists of a silicon nitride layer having a thickness of, for example, 100 nm and, as the case may be, an underlying very thin oxide or oxynitride layer (not shown). The masking layer in this embodiment and in the following embodiments consists of a patterned silicon layer along which an edge portion of silicon oxide is formed. In this embodiment, this masking layer is provided by first covering the oxidation-preventing layer 2 by a first silicon layer. The first silicon layer 3 in this embodiment is a polycrystalline silicon layer having a thickness of about 2 um. The layer 3 can be deposited by means of methods well known in the semiconductor technology, which need not be described further herein. Although this is not necessary, the silicon layer 3 is preferably provided with a thin (for example 200 nm thick) oxide layer 4, which facilitates the etching step and to which a photoresist mask adheres satisfactorily (cf. Fig. 13). By means of known photolithographic etching methods, the first silicon layer 3 is now patterned and this pattern consists in this embodiment of one or more rectangular blocks. Finally, the layer 3 is partly oxidized in order to form at least an oxidized edge portion 5 thereof (cf. Fig. 14).

The uncovered parts of the oxidation-preventing layer 2 are now removed by etching without a mask, the parts located below the silicon layer 3 and the edge portion 5 being maintained. Subsequently, the edge portion 5 is removed also by etching without a mask and the exposed silicon of the substrate region 1 and of the layer 3 is thermally oxidized, the oxide layer 6 and the oxide pattern 70 sunken partly into the substrate region 1 being obtained (cf. Fig. 15).

The exposed parts of the oxidation-preventing layer 2 are now etched away without a mask and one or more grooves 80 are etched anisotropically in the substrate region 1. This may be effected by plasma etching, for example, in a chlorine-containing plasma. These grooves have a width of, for example, 0.7 µm. The substrate region 1 in this embodiment comprises an $\underline{n}$-type epitaxial layer 9 having a thickness of 1.5 µm and a doping of $10^{16}$ phosphorus atoms per $cm^3$, which is located on a $\underline{p}$-type subjacent layer 10, a more highly doped buried layer 11 of the $\underline{n}$-type having a thickness of about 2 µm being situated between the subjacent layer 10 and the epitaxial layer 9. The groove 80 in this embodiment has the form of a rectangle and extends beyond the buried layer 11 (cf. Fig. 16).

In this variation of the method according to the invention, the groove 80 is filled, as the case may be after implantation of a channel stopper (CS) in the groove bottom (shown in dotted lines in the Figures and not always necessary), with a filler material, which mostly, also in this embodiment consists of polycrystalline silicon. For this purpose, the groove is first provided by thermal oxidation with an oxide layer 12 (cf. Fig. 16). Subsequently, polycrystalline silicon 13 is deposited, which fills the groove 80 and covers the surface, after which an etching treatment is carried out until polycrystalline silicon is left only in the groove (cf. Fig. 17). In this embodiment and the following four embodiments, the groove thus filled with silicon and silicon oxide constitutes the island insulation region.

Subsequently, a photoresist layer 14 is provided on the assembly as far as above the oxidized first silicon layer 3,6. For example by plasma etching, the resist layer 14 is etched dry until the upper side of the oxidized first silicon layer (3,6) is exposed (cf. Fig. 17), after which the uncovered silicon oxide 6 thus exposed is etched away and the resist 14 is entirely removed. The uncovered silicon (3 and 13) is subjected to a light thermal oxidation, in which a silicon oxide layer 15 is formed and the situation of Fig. 18 is obtained. In order to ensure that the etching treatment (planarization) of the photoresist 14 is effected satisfactorily, photoresist blocks 14A, whose boundaries are indicated by dotted lines in Fig. 17, are provided preferably with a non-critical mask at a distance of a few microns from the silicon 3.

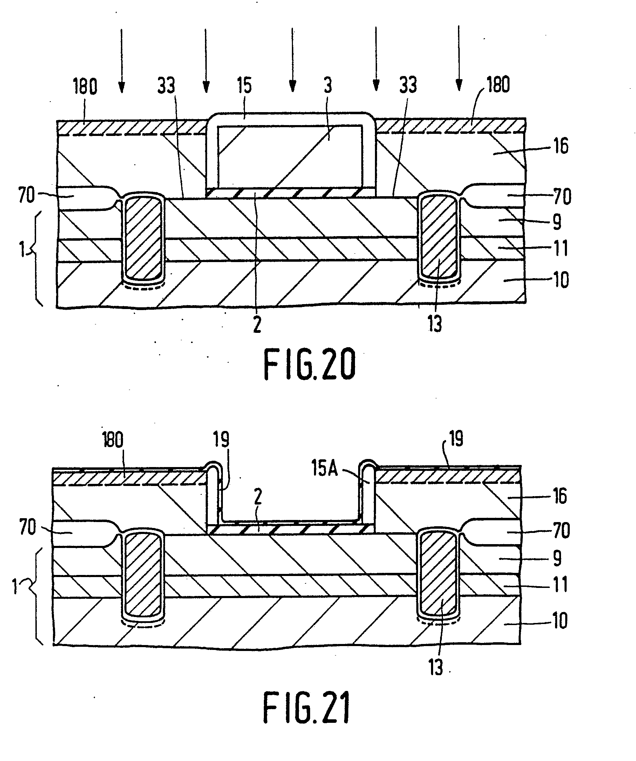

The uncovered parts of the oxidation-preventing layer 2 are now etched away without a mask, after which a second silicon layer 16 having a thickness of 0.6 to 0.7 μm is formed (cf. Fig. 19), which is then etched away from the upper side of the oxidized first silicon layer 3. In this embodiment, this is effected again by planarization, a resist layer 140, for example a photoresist layer, being provided on the silicon layer 16 (cf. Fig. 19) and then being subjected together with the layer 16 to a dry etching treatment until the oxidized upper side 15 of the first silicon layer is exposed (cf. Fig. 20). Also in this case, like in Fig. 17, photoresist blocks 140A can again be provided in order to facilitate the planarization.

Subsequently, an implantation with boron ions is carried out, in which a p-type layer 180 having a doping of more than $6.10^{19}$ boron atoms per $cm^3$ is obtained in the layer 16 (cf. Fig. 20); the oxide layer 15 masks against this implantation, which serves to render the layer 3 selectively etchable with respect to the layer 180.

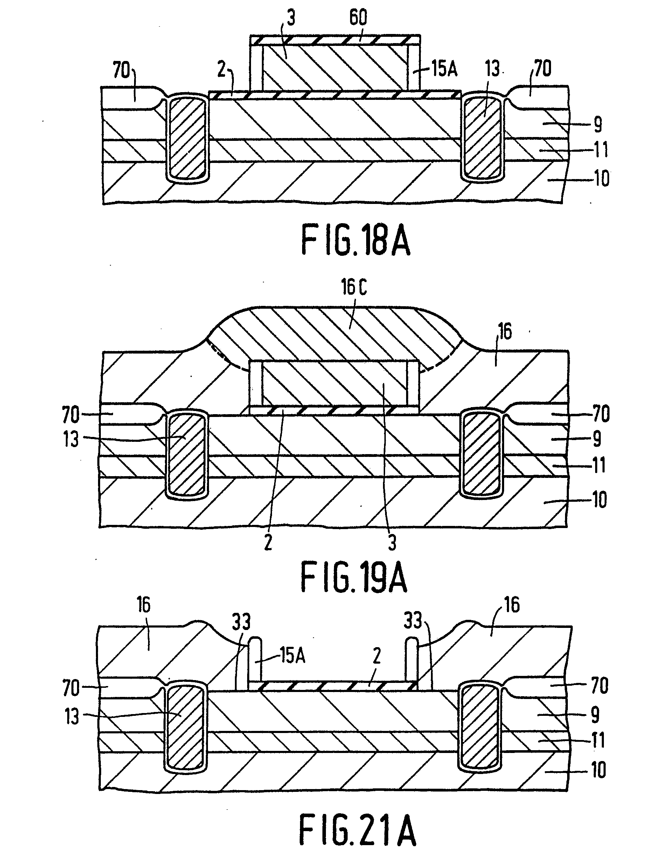

The oxide 15 is then removed from the upper side of the layer 3 by anisotropic etching; the oxide wall 15A is then maintained (cf. Fig. 21). This may be effected again, for example, by plasma etching in a fluorine-containing plasma.

Subsequently, the undoped silicon layer 3 is selectively etched away, for example with a mixture of KOH, isopropanol and water. For this etchant the etching rate of undoped silicon is considerably higher than that of the highly doped p-type layer 180.

Hitherto, only one mask has been required for carrying out the successive processing steps, i.e. only for one masking step for patterning the layer 3.

Subsequently, zones of a semiconductor circuit element are formed in the part of the substrate limited by the groove. This may be effected with the use of masking by the silicon layer (16/180) and the oxide wall 15A to a considerable extent in a self-aligned manner. The formation of a bipolar npn transistor having very small dimensions will be illustrated with reference to Figures 21 to 25.

First (cf. Fig. 21) a thin layer 19 of silicon nitride is deposited, which entirely covers the silicon layer 16 and also reaches the layers 2 and 15A.

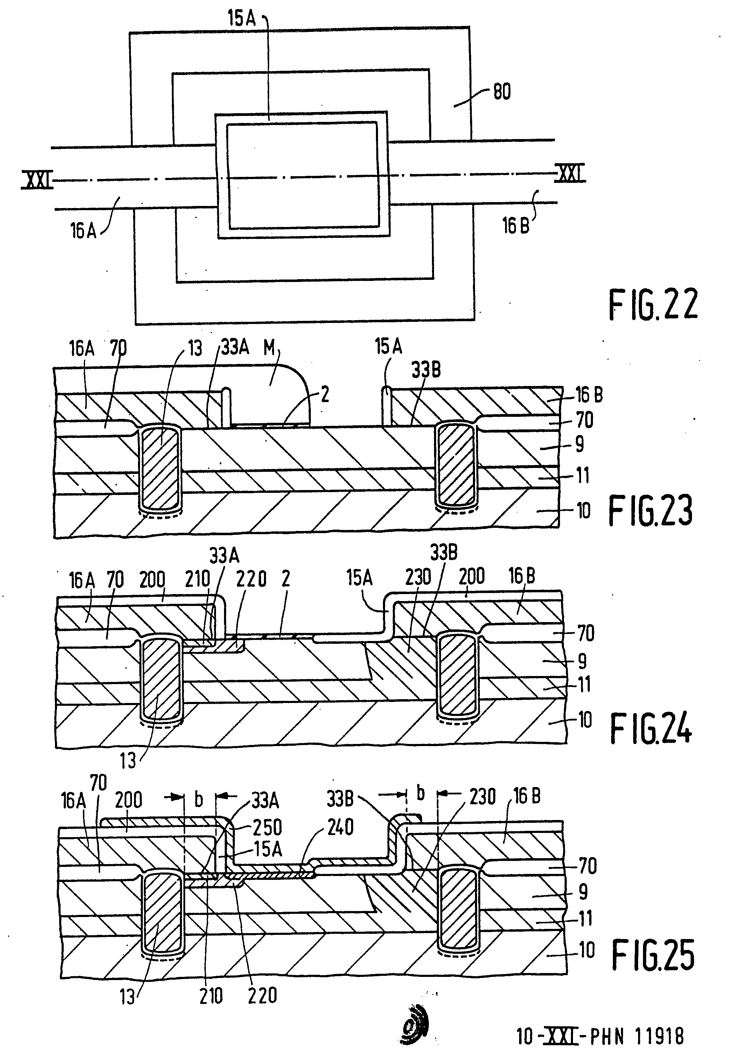

By means of photolithographic etching, the silicon nitride 19 is now etched into the desired pattern, after which the wiring pattern is formed in the layer 16, for example by dry etching with the use of the resist mask still present on the nitride layer 19 as a masking, the layer parts 16A and 16B shown in plan view in Fig. 22 being maintained. These layer parts 16A and 16B are then covered by nitride.

The sides of the silicon layer 16 are now thermally oxidized. By means of non-critical photoresist masks, after removal of the nitride layer 19 (the layer 2 being maintained for the major part because of its larger thickness), in order of succession the layer 16A is doped with arsenic and boron and the layer 16B is doped with arsenic and phosphorus by ion implantation (the layer 16B becomes entirely n-type conducting by overdoping and by
oxidation of the p-type layer 180). The arsenic implantation
may have, for example, a dose of $10^{16}$ ions per $cm^2$ and an
energy of 100 keV and the phosphorus implantation may have
a dose of $2.10^{16}$ ions per $cm^2$ and an energy of 30 keV.
The layer parts 16A and 16B now form connection electrodes
on the electrode regions 33A and 33B of the semiconductor
element. By means of the mask M used for the phosphorus
implantation (cf. Fig. 23), the nitride or nitride/oxynitride layer 2 is further etched away within the window
limited by the oxide wall 15A.

Subsequently, after removal of the masking, the
exposed silicon is thermally oxidized, the oxide layer 200
then being obtained (cf. Fig. 24). Arsenic and boron then
diffuse from the doped silicon layer 16A into the epitaxial
layer 9, the arsenic forming the n-type emitter zone 210
and the boron – because of its larger diffusion coefficient-
diffusing further and forming the p-type base zone 220.
Phosphorus diffuses from the layer 16B into the buried
n-type layer 11 and thus forms the collector contact region
230 (cf. Fig. 24).

Finally, the remaining parts of the layer 2 are
etched away without a mask and a boron implantation 240
is carried out, which contacts the base zone 220. This
contact zone 240 can then be contacted with a conductive
layer 250 of, for example, metal or silicon in order to
form the base connection (cf. Fig. 25). The polycrystalline
silicon layer 16A, in which the arsenic concentration is
higher than the boron concentration, forms the n-type
emitter connection and the n-type silicon layer 16B forms
the collector connection of the transistor. The emitter-base
junction terminates below the oxide wall 15A.

In the manufacture described above of the transistor, the first masking step, which determines the structure
shown in Fig. 14, defines at the same time the positions
of (a) the field oxide region 70, (b) the groove insulation
80, (c) the base zone 220, (d) at least one edge of the base
zone 240, (e) the emitter zone 210, (f) the collector contact region 230 and (g) the distance of the base contact zone 240 from the emitter zone 210. As a result, a large number of critical masking and alignment steps are economized, which otherwise would require additional space. The dimensions of the transistor can therefore be very small. For example, with the transistor shown in Fig. 25, when using conventional lithography, the space within the groove 80 can have a length of 4 μm and a width of 3 μm. The width $\underline{b}$ of the connections to the silicon layers 16A and 16B is, for example, 0.6 μm, but may lie in practice between 0.1 and 1.0 μm.

It should be noted that the processing steps of Figs. 8 to 21 may also be carried out in a different manner, as a result of which a planarization step can be avoided. For this purpose, the first silicon layer 3 is given a high $\underline{n}$-type doping and this layer 3 is provided on the upper side with an anti-oxidation layer, for example a silicon nitride layer 60, as a result of which only the sides of the layer 3 are oxidized. Instead of Fig. 18, the situation of Fig. 18A is then obtained. Subsequently, the nitride layer 60 and the exposed parts of the layer 2 are etched away without a mask, whereupon a second $\underline{p}$-type conducting layer 16 is provided on the assembly (cf. Fig. 19A). During a heating step, such a quantity of donor impurity is then diffused from the layer 3 into the layer 16 that the part 16C between the dotted lines becomes $\underline{n}$-type conducting, while the remaining part of the layer 16 remains $\underline{p}$-type conducting. By means of a selective etching process, the part 16C of the layer 16 is now removed simultaneously with the layer 3, as a result of which the situation of Fig. 21A is obtained, which corresponds to that of Fig. 21. The further process is effected in the manner already described.

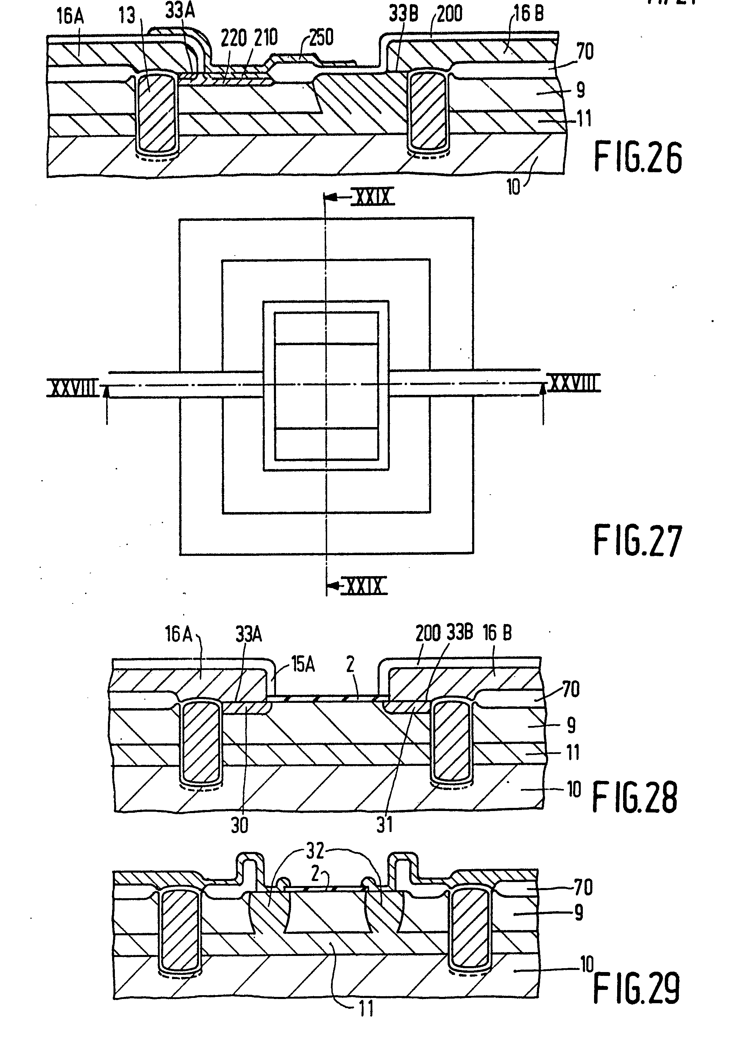

Different variations of the above embodiment are possible by changing the order of succession of doping and the masks. For example, the masking for defining the wiring to be formed from the silicon layer 16 may also be used to etch away a part of the anti-oxidation layer 2 and to form at this area upon oxidation of the silicon wiring (16A, 16B) a sunken oxide pattern, which separates the base zone from the collector region. The p-type layer 16A ( doped with boron) then serves as a base connection and the n-type layer 16B serves as a collector connection; the structure becomes such as indicated in Fig. 26.

Instead of a vertical bipolar npn transistor, as in the above embodiment, another semiconductor circuit element may also be formed in the region bounded by the grooves 80. Figures 27 to 29 show by way of example a lateral pnp transistor.

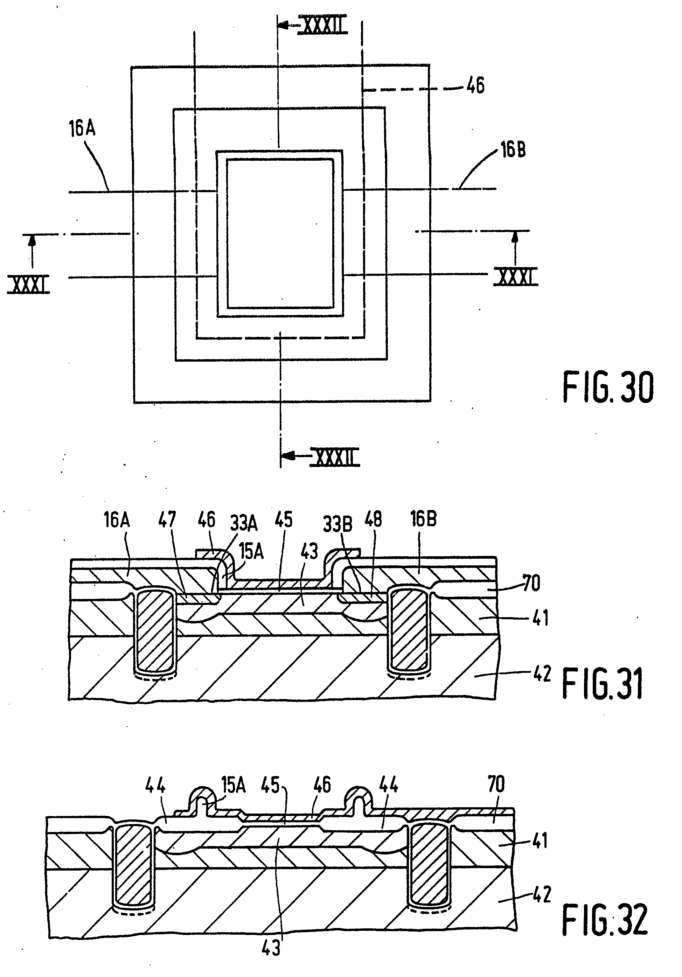

Fig. 27 shows such a transistor diagrammatically in plan view, while Figures 28 and 29 show cross-sections in the directions XXVIII and XXIX, respectively, of Fig. 27. The emitter and collector connection conductors 16A and 16B are again formed in the same manner as in the preceding embodiments and are both p-doped. The layer 2 is locally removed by means of a mask which also determines the implantation for the base contact zone 32. The emitter and collector zones 30 and 31 are diffused from the p-type layers 16A and 16B. The remaining part of the nitride or nitride/oxynitride layer 2 must be maintained in order to prevent reduction of the efficiency due to surface states, for example oxidation of the intermediate silicon surface.

It is also possible to manufacture an n-channel or a p-channel MOS transistor in a manner which is analogous to the manufacture of the lateral pnp transistor of Figs. 27 to 29.

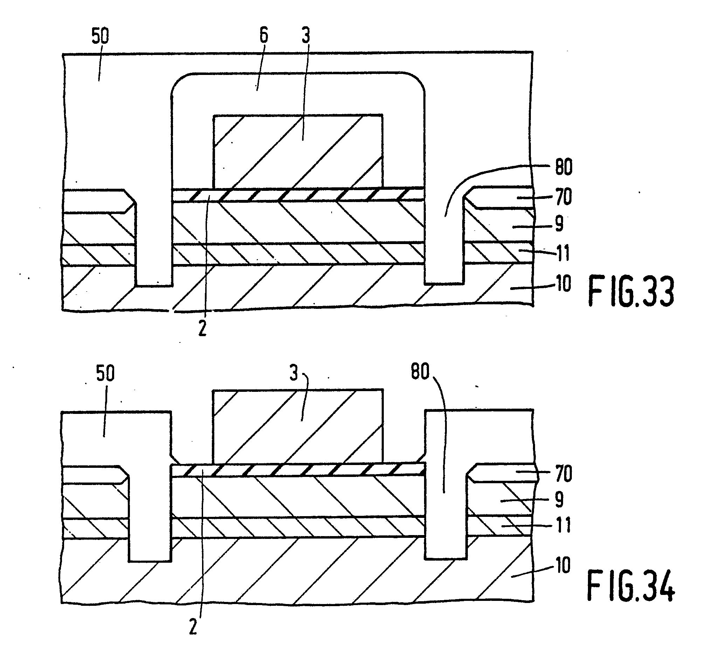

The structure of an n-channel MOS transistor is shown in plan view in Fig. 30 and in Figures 31 and 32 in cross-section along the directions XXXI and XXXII of Fig. 30. The starting material is, for example, an n-type epitaxial layer 41 which is formed on a p-type substrate 42 (cf. Fig. 31). After the groove filled with polycrystalline silicon 13 has been provided in the manner described above, a p-type region 43 is formed within the groove in a self-aligned manner, the sunken oxide pattern 70 and the filled groove masking against the implantation. The doping of the region 43 can take place by ion implantation and at a further stage by diffusion of boron from the silicon layers 16A and 16B.

Within this p-type region 43, the MOS transistor is formed. By means of a first etching mask, the silicon wiring (16A, 16B) is defined, like in the preceding embodiments, while at the same time by means of this mask the parts of the oxidation-preventing layer 2 located outside it are etched away and a channel stopper zone may be implanted with the use of the same mask. After the silicon nitride present on the layers 16A and 16B has been removed, these silicon layers are doped, for example, with boron and arsenic in such a manner that they altogether become n-type conducting. This doping may also take place before patterning of the layers 16A and 16B.

A thermal oxidation is then carried out, in which a thick oxide layer 44 is formed on the uncovered parts of the silicon surface located within the groove (cf. Fig. 32). In this case, the donor and acceptor elements also diffuse from the layers 16A and 16B in order to form the n-type source and drain zones 47 and 48 and the edge of the p-type region 43.

Subsequently, the remaining part of the oxidation-preventing layer 2 is etched away and a thin gate oxide layer 45 is formed by thermal oxidation (cf. Fig. 31 and Fig. 32). On this layer and on the thick oxide layer 44 a control electrode 46 is then formed consisting of a metal layer, a metal silicide layer or a silicon layer.

In the same manner, a p-channel MOS transistor can be formed in that, for example, in Figs. 31 and 32 the p-type region 43 is omitted and the silicon layers 16A and 16B are p-doped.

Many other variations are possible. In the silicon connection wires 16A and 16B, polycrystalline resistors may be formed at previously selected areas by means of suitable dopings. Alternatively, Schottky diodes, pn diodes, pn junction field effect transistors (JFET's) etc. may be provided in the windows bounded by the oxide edge 15A, the starting material in all these cases advantageously being the structure of Fig. 21 obtained by means of the method according to the invention.

Another variation is the possibility that first the groove is filled with resist, which is then removed, and that only then the groove wall is oxidized and the groove is filled with polycrystalline silicon. Starting from the stage of Fig. 15, the exposed part of the anti-oxidation layer 2 is then first etched away. Subsequently, the groove or grooves 80 is or are etched and the assembly is covered with a (photo)resist layer 50 (cf. Fig. 33).

By dry etching, the resist layer 50 is then etched away in part in such a manner that the oxide 6 is exposed. This oxide 6 is then etched away (cf. Fig. 34). Subsequently, the resist 50 is entirely removed, whereupon the first silicon layer 3 and the groove wall are oxidized, the grooves are filled with polycrystalline silicon (by deposition and subsequent etching) and the polycrystalline silicon 13 is oxidized. The situation of Fig. 18 is then obtained again.

In the Figures 35 to 44, successive stages of a still further embodiment of the method according to the invention are shown in cross-section. The starting material (cf. Fig. 35) is a substrate region 1 of silicon, which in this embodiment consists of a p-type substrate 10, an n-type epitaxial layer 9 disposed thereon and a highly doped n-type buried layer 11. In a first processing step, an oxidation-preventing layer 2 and a first about 2 μm thick silicon layer 3 are formed successively on the substrate region 1 on the surface of the epitaxial layer 9. The layer 2 consists of an about 80 nm thick layer of silicon nitride, as the case may be with an underlying very thin layer of silicon oxide or silicon oxynitride (not shown). The layer 3 will be deposited on the nitride in the form of polycrystalline silicon.

In this embodiment, an about 100 nm thick second oxidation-preventing layer 62 covered with a pyrolytically formed oxide layer 63 is further provided on the silicon layer 3. The said layers may all be deposited in a usual
manner from the gaseous phase; for example, the layer 3
may be deposited from a gas mixture comprising a silicon
compound, such as silane ($SiH_4$), while the nitride layers
2 and 62 may be deposited from gas mixtures comprising
$SiH_4$ and $NH_3$. There is extensive literature about these
techniques, of which the details are not essential to the
invention.

By masking and etching, the first silicon layer
3 is now patterned so that the silicon is maintained at
the area of the island-shaped region to be formed.
Subsequently, the silicon layer 3 is partly oxidized,
a first oxidized edge portion 5 being formed (cf. Fig. 36).

The uncovered part of the oxidation-preventing
layer 2 is now etched away, just like the oxide layer 63
and the oxide or oxynitride that may be present below the
nitride layer 2; the thicker oxidized edge portion 5 is
then maintained for the major part (cf. Fig. 37).

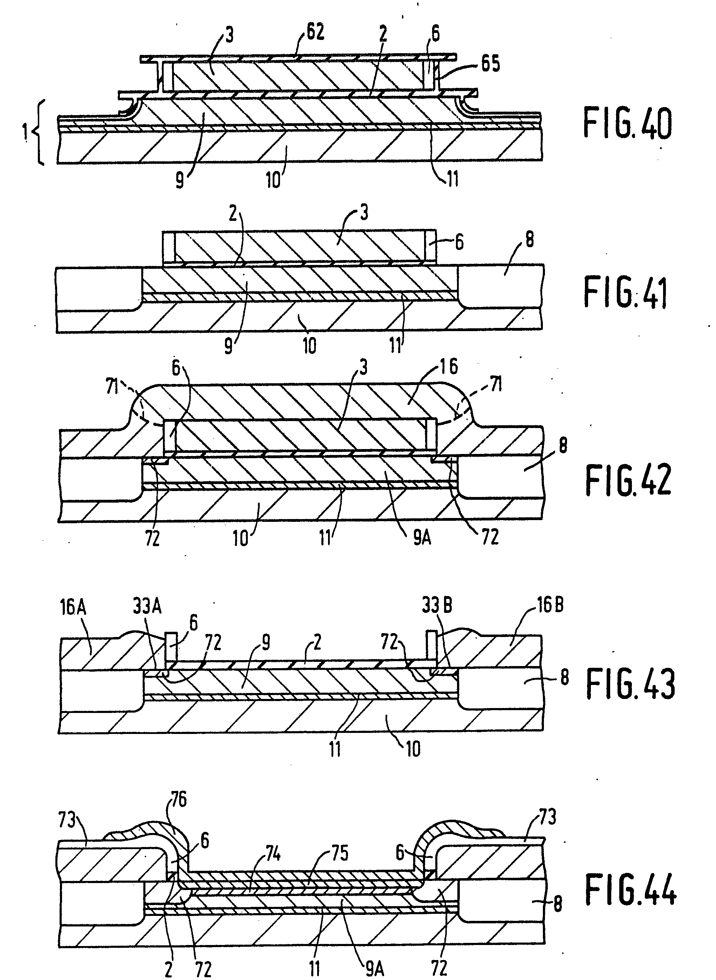

Subsequently, in this embodiment, the uncovered
part of the substrate region 1 is partly etched away, as
a result of which a mesa structure is obtained (cf. Fig.
38). The first oxidized edge portion 5 is then etched away,
whereupon a thinner second oxidized edge portion 6 of the
first silicon layer 3 and also an oxide layer 64 are formed
by thermal oxidation (cf. Fig. 39). A further oxidation-
preventing layer, for example a silicon nitride layer 65,
is then deposited on the assembly. By plasma etching, for
example, in a fluorine-containing plasma, the parts of the
thin nitride layer 65 exposed to the plasma are then
removed, the parts of the layer 65 present below the
overhanging parts of the thicker nitride layers 2 and 62
being maintained (cf. Fig. 40).

Subsequently, by thermal oxidation at, for example,
1000°C in moist oxygen, an island insulation region in the
form of a sunken oxide pattern 8 is formed, after which
all the exposed parts of the oxidation-preventing layers
2, 62 and 65 are etched away and the structure of Fig. 41
is obtained.

According to the invention, a second silicon layer 16 is now deposited, which contacts the island-shaped region 9A surrounded by the insulation region 8 (cf. Fig. 42.)

The part of the second silicon layer 16 located above the first silicon layer 3 is now removed without a mask. In this embodiment, this is effected in the following manner.

A highly doped $\underline{n}$-type layer is used as the first silicon layer 3. The second silicon layer 16 is in this case a $\underline{p}$-type layer, which, however, has a lower doping than the layer 3. The doping can take place during the deposition or, as the case may be, thereafter by ion implantation. After the deposition of the layer 16, the donor impurity is diffused by heating from the layer 3 into the layer 16, as a result of which the latter layer is redoped between the dotted lines 71 to the $\underline{n}$-type. Subsequently, by means of an etching liquid, for example a KOH-containing etchant, the $\underline{n}$-type part of the layer 16 and the layer 3 are both etched away selectively so that the structure of Fig. 43 is obtained. During the said heating, the acceptor impurity is diffused from the layer 16 (which has previously been shaped by etching into the form of the desired electrodes 16A and 16B) into the island-shaped region 9A and forms there the $\underline{p}$-type contact zones 72 (cf. Figs. 42-43).

Subsequently, the electrodes 16A and 16B are thermally oxidized, as a result of which the oxide layer 73 is obtained (cf. Fig. 44). The oxidation-preventing layer 2 is then etched away selectively and the active $\underline{p}$-type base zone 74 and the $\underline{n}$-type emitter zone 75 are formed by ion implantation and/or diffusion, the oxidized silicon layers 16A and 16B, the oxidized edge portions 6 and the sunken oxide pattern 8 being used as a mask so that also in this case no additional masking and alignment step is required. Finally, the emitter zone is contacted with an emitter contact metallization 76 (cf. Fig. 44). The collector zone 9A is contacted in a usual manner (outside the plane of the drawing) by means of an n-type connection zone extending from the surface to the buried layer 11.

As will appear from the following embodiment, the formation of a second oxidized edge portion 6 of the first silicon layer 3 is not absolutely necessary. Figures 45 to 50 show diagrammatic cross-sections of a semiconductor device at successive stages of manufacture according to another preferred embodiment of the method.

Like in the preceding embodiment, the starting material is again a substrate region 1 consisting of a substrate 10 of a first conductivity type, an epitaxial layer 9 of the second opposite conductivity type and a buried layer 11 which is highly doped and is also of the second conductivity type. In this practical case, again a p-type substrate 10 with an n-type layer 11 is chosen, although the conductivity types could also be replaced by the opposite conductivity types. Again an oxidation-preventing layer 2, preferably consisting of silicon nitride and mostly formed on a very thin oxide or oxynitride layer (not shown) is provided on the epitaxial layer 9. The first n-type silicon layer 3 is deposited thereon and an oxidation-preventing layer 62 of, for example, silicon nitride is again provided on this layer, an oxide layer 63 being deposited on this layer 62.

After the silicon layer 3 has been patterned and a first oxidized edge has been formed by thermal oxidation, which may be effected in the same manner as in the first embodiment, the exposed part of the oxidation-preventing layer 2 is removed by etching and a part of the substrate region 1 thus exposed is etched away. In contrast with the preceding embodiment, the oxidized edge portion 5 is not removed now, but a silicon nitride layer 66 is deposited on the assembly so that the structure of Fig. 45 is obtained. By plasma etching, the nitride layer 66 is now removed anisotropically, the layer 66 being maintained on vertical surfaces and at areas at which it is protected from etching by overhanging layer parts. The result is the structure of Fig. 46.

Subsequently (cf. Fig. 47), the uncovered silicon
is oxidized at about 1000°C in moist oxygen, the island
insulation region 81 then being obtained.

Thereafter, first the silicon nitride layer 66
and then the oxide layer 63 are etched away, whereupon
a second highly doped p-type silicon layer 16 is provided
on the assembly (cf. Fig. 48).

By planarization and plasma etching, the layer
16 is now removed above the layer 3. For this purpose,
first a resist layer, preferably a photoresist layer,
is provided as far as above the highest point of the
layer 16, whereupon this layer is etched in a usual manner
together with the resist layer by plasma etching until the
upper side of the layer 3 is reached. For technical details
of this usual etching method, reference is made for all
embodiments to the article by Nakamura et al, IEDM 1982,
p. 684-687. After the silicon nitride 62, the oxidized
edge portion 5 and the resist have been removed, the
situation of Fig. 49 is then obtained, after which p-type
contact zones 82 are formed in the epitaxial layer 9 by
ion implantation.

After the second silicon layer 16 has been etched
into the desired pattern of electrodes (16A, 16B) and the
remaining part of the first silicon layer 3 has been
removed selectively, for example by etching in a KOH-
containing etching liquid, the electrodes 16A and 16B are
oxidized, p-type zones 83, which adjoin the p-type contact
zones 82, being formed by diffusion of acceptor impurities
from the layers 16A and 16B (cf. Fig. 50).

The collector zone 9 can again be contacted
via an n-type connection zone extending from the surface
to the buried layer 11.

In this preferred embodiment, only one oxidized
edge portion 5 is therefore used. On the other hand,
however, the contact zones 82 and the p-type zone 83 are
formed in two steps.

Another embodiment is illustrated with reference
to Figures 51 to 59. Again the starting material is a

0246682

substrate region 1 of silicon composed of a p-type substrate 10, an n-type epitaxial layer 9 and a highly doped n-type buried layer 11. A thin (about 30nm thick) oxide layer (not shown) and a 120 nm thick silicon nitride layer 2 are successively provided on this substrate 1. A polycrystalline first silicon layer 3 having a high n-type doping is provided thereon and a 100 nm thick nitride layer 62 and a pyrolytically deposited oxide layer 63 are formed on the latter layer.

Subsequently, the layers 63, 62 and 3 are shaped by masking and etching into the desired form corresponding to that of the island to be formed. By thermal oxidation, again a first oxidized edge portion 5 is formed on the first silicon layer 3. The uncovered part of the oxidation-preventing layer 2, inclusive of the underlying thin oxide layer, is then removed, whereupon the substrate region 1 is etched away beyond the buried layer 11, the cavity 92 then being obtained. Thus, the structure of Fig. 51 is obtained.

Subsequently, after a light thermal oxidation, a silicon nitride layer 90 and a pyrolytic silicon oxide layer 91 are formed on the assembly (cf. Fig. 52). By anisotropic plasma etching, these layers 90 and 91 are then removed again except the parts present on the vertical surfaces (cf. Fig. 53). The oxide layer 63 has such a thickness that it is maintained in part.

Polycrystalline silicon 93 is now deposited on the assembly and is then removed again by plasma etching until the silicon 93 is maintained only in the cavity 92. Subsequently, in a further etching step in a HF-containing etching liquid, the oxidized edge portion 5, the uncovered parts of the oxide layer 91 and the oxide layer 63 are removed (cf. Fig. 54).

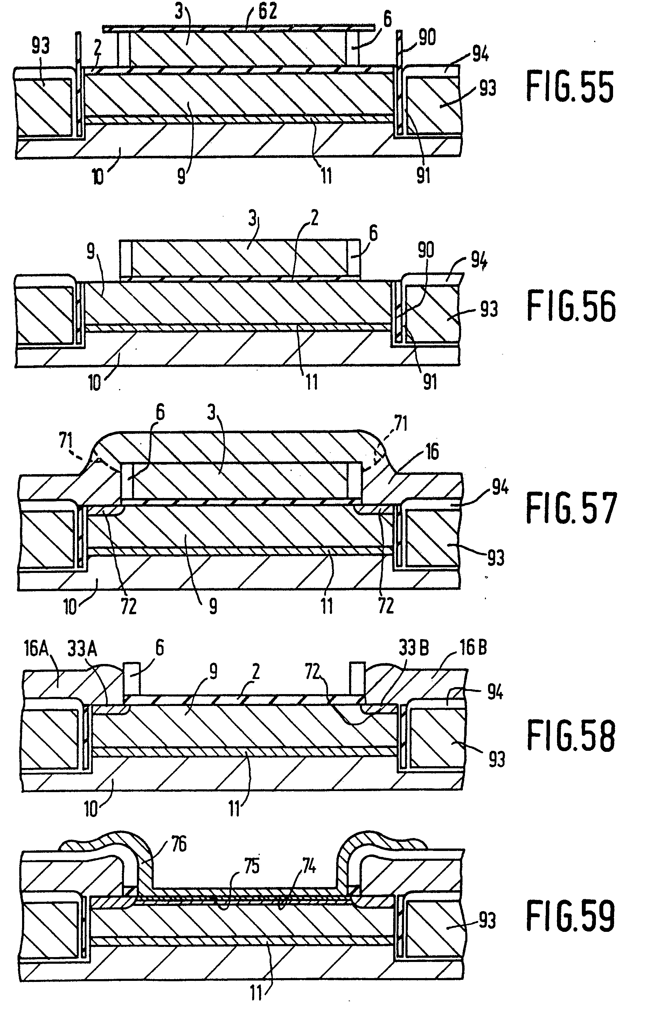

Subsequently, by a thermal oxidation the first silicon layer 3 is provided with second oxidized edge portions 6. An oxide layer 94 is then formed on the polycrystalline silicon 93 (cf. Fig. 55).

The uncovered silicon nitride is then etched
away so that the structure of Fig. 56 is obtained.
A polycrystalline second silicon layer 16 receiving a
strong p-doping is then provided on the assembly
(cf. Fig. 57). This can be effected during the deposition
by addition of an acceptor to the gas mixture or after
the deposition by ion implantation or diffusion.

By heating, a donor impurity is now diffused
from the layer 3 into the layer 16. The dopings of the
layers 3 and 16 are chosen so that the p-type layer 16
is locally converted into n-type by this diffusion, i.e.
between the dotted boundary lines 71 (cf. Fig. 57).
During this diffusion, p-type contact zones are further
diffused into the n-type epitaxial layer 9 in the same
manner as in the embodiment shown in Figures 35 to 44.

Within the oxide edge 6, the layer 2 is now
exposed in that the n-type layer 3 and the n-type parts
of the layer 16 located above it are etched away selectively
with a KOH-containing etching liquid (cf. Fig. 58).
By thermal oxidation, the electrodes 16A and 16B (shaped
beforehand by etching into the desired pattern) are provided
with an oxide layer 73 (cf. Fig. 59).

Subsequently, the exposed parts of the nitride
layer 2 are etched away, after which the p-type base zone
74 and the n-type emitter zone 75 are implanted.
After the emitter zone 75 has been contacted with an
emitter metallization 76, the transistor structure of
Fig. 59 is obtained, in which the collector is connected
(outside the plane of the drawing) via an n-type connection
zone to the buried layer 11.

In the two preceding embodiments described, only
one etching mask used till the step of etching electrodes
from the second silicon layer 16 is used. All the further
etching, oxidation and implantation steps are effected
entirely in a self-aligned manner. As a result, the surface
of the semiconductor circuit elements obtained and more
particularly that of the contact zones 72 can be particularly small at the area at which the silicon connection conductors contact the element.

The method according to the invention may also be used advantageously in the manufacture of a memory cell having particularly small dimensions. With reference to Figures 60 to 69, the manufacture of a DRAM (Dynamic Random Access Memory) cell will be described.

Fig. 60 shows in plan view a few DRAM cells monolithically integrated in a memory. Fig. 61 shows diagrammatically in cross-section taken on the line BB in Fig. 60 such a memory cell and Fig. 61A shows the same cell in cross-section taken on the line AA. The cell consists of a substrate region 101, in this embodiment of p-type silicon, of which a part is bounded laterally within the memory cell by a groove, whose bottom and wall are covered with a dielectric material, this groove further being filled with polycrystalline silicon 104. Within the memory cell, an n-type contact region 107 is present at the surface and this region is contacted by a conductor 108, which acts as a "BIT" line. A $p^+$ conducting "WORD" line 116 of polycrystalline silicon insulated therefrom is insulated from the substrate region 101 and from the polycrystalline silicon lines 108 and is partly located on the gate oxide 117. The memory cell comprises a capacitor, of which the capacitor plates are constituted on the one hand by the polycrystalline silicon 104 applied to a reference potential, for example to earth, and on the other hand by the part of the substrate region 101 enclosed by the groove. The dielectric of the capacitor consists of the dielectric layers 112 and 113 on the wall and the bottom of the groove and of the depletion region 118 (indicated by dotted lines) within and along the groove.

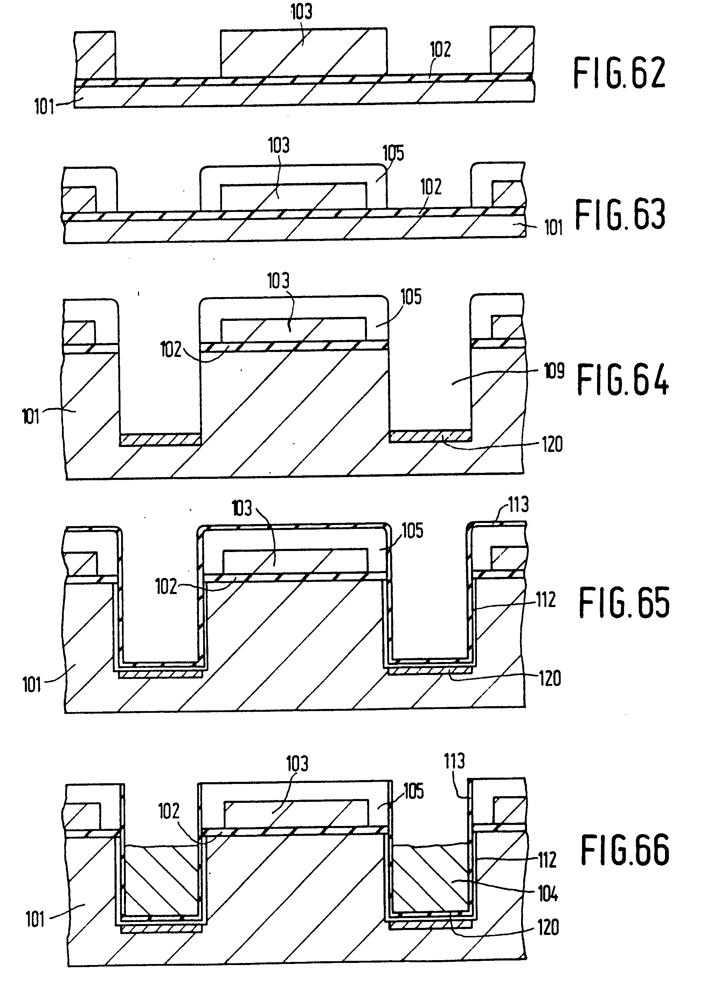

This DRAM cell can be manufactured for the major part in a self-aligned manner by the use of the method according to the invention and can then have a surface area of less than 10 $\mu m^2$. An example of such a manufacturing method will now be described with reference to Figures 62 to 69A. Like in the preceding embodiments, the starting material is a substrate region 101, in this embodiment

therefore of p-type silicon, on which an oxidation-preventing layer 2 of silicon nitride is provided, which may be located on a very thin layer of silicon oxide or oxynitride (not shown here).

A masking layer consisting of a patterned layer of silicon is provided thereon, along which an edge portion of silicon oxide is formed. For this purpose, the oxidation-preventing layer 102 is first covered by a first silicon layer 103 of undoped silicon. The layer 103 is then subdivided by masking and etching into square or rectangular parts at the area of the DRAM cells to be formed. Fig. 62 shows a cross-section of one of these parts taken on the line BB in Fig. 60. In this embodiment, silicon layer parts or blocks 103 will be used, which are not covered by a nitride layer. During a thermal oxidation, the blocks 103 are therefore also covered with oxide on the upper side (cf. Fig. 63). A part of this oxide forms the oxidized edge portions 105.

Subsequently, the exposed part of the oxidation-preventing layer 102 is etched away selectively and the groove 109 is formed in the substrate region 101 by anisotropic plasma etching (cf. Fig. 64). By implantation of boron ions, the channel stopper zone 120 is formed in the bottom of the groove.

Subsequently, the wall and the bottom of the groove 109 are provided by thermal oxidation with an about 10 nm thick layer 112 of silicon oxide. An also about 10 nm thick layer 113 of silicon nitride is then provided thereon (cf. Fig. 65).

The assembly is then covered by a layer of polycrystalline silicon, which is subsequently etched until silicon (104, cf. Fig. 66) is left in the grooves only.

The horizontal parts of the thin nitride layer 113 extending parallel to the surface are now removed, in this embodiment by plasma etching, the vertical parts being maintained. Thus, the situation of Fig. 66 is obtained.

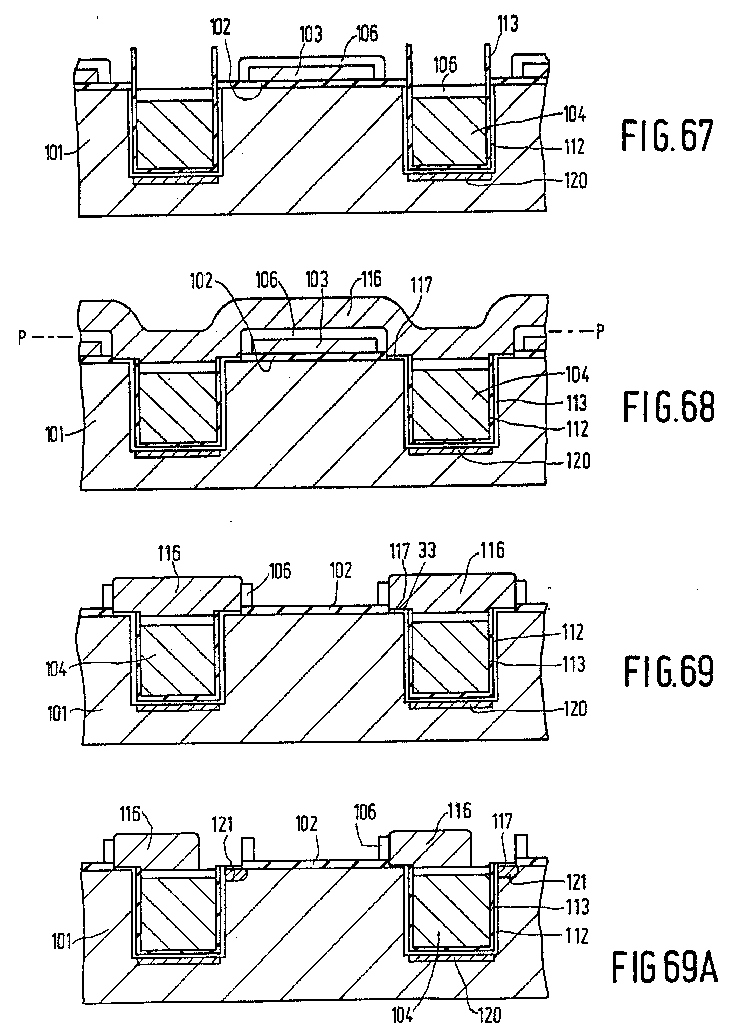

By implantation or by diffusion of, for example, phosphorus, the polycrystalline silicon 104 is now made strongly n-conducting. The oxide layer 105 and the silicon layer 103 mask against this implantation. Subsequently, the oxide 105 is removed and a new oxide layer 106 is formed by thermal oxidation on the silicon 103 and 104 (cf. Fig. 67).

Now the uncovered parts of the oxidation-preventing layer 102 and the nitride layer 113 are etched away selectively, whereupon a thin about 20 nm thick "gate" oxide layer 117 is formed by a light thermal oxidation on the silicon surface thus exposed, after which a layer 116 of polycrystalline silicon is deposited on the assembly (cf. Fig. 68). This layer 116 is then strongly p-doped by a boron implantation. The doping may also be provided already during the deposition of the layer 116.

By planarization and plasma etching, the layer 116 is now etched away as far as the level P-P indicated by dotted lines. Subsequently, the oxide 106 on the silicon layer 103 is etched away and the undoped silicon 103 is then selectively removed with a KOH-containing etchant, the situation of Fig. 69 thus being obtained.

The layer 116 is now shaped into the desired "word line" pattern by masking and etching, whereupon by implantation of boron ions a channel stopper zone 121 is formed in those parts of the substrate 1 which are only located below the thin oxide 117. This zone 121, which prevents that parasitic channels are formed in the case of a slightly oblique alignment of the etching mask for the word line 116, is shown in Fig. 69A, which shows a cross-section taken on the line AA in Fig. 60, so at right angles to the cross-section of Fig. 69.

Subsequently, the word line 116 is fully covered with oxide 122 by thermal oxidation, whereupon the anti-oxidation layer 102 is etched away and arsenic ions are implanted and then diffused in the window thus obtained in order to form the n-type contact zone 107. After the bit line 108 has been formed by vapour deposition and patterning of an aluminium layer, the situation of Fig. 61 and 61A is obtained.

Simultaneously with this memory cell, all the remaining memory cells are formed, of which six are shown in plan view in Fig. 60. The memory cell corresponds in electrical respect to the circuit diagram shown in Fig. 61B, in which the reference numerals corresponding to Figs. 61 and 61A are used. By a signal at the word line 116, the bit line 108 is connected to the capacitor (101, 104) and the charge stored in the dielectric of this capacitor can be read out.

By means of 1.5 µm lithography, $\underline{i.e.}$ lithography in which the smallest details are 1.5 µm, a DRAM cell having a surface area of 9 µm$^2$ can thus be manufactured. By means of 1 µm lithography, the attainable surface area even amounts to 4 µm$^2$.

It will be appreciated that many variations are possible within the scope of the invention so that many other semiconductor structures with submicron distances can be manufactured. For example, in general, in the embodiments described, the conductivity types may be replaced (all simultaneously) by the opposite conductivity types provided that the etchants are adapted thereto. Furthermore, the said insulating layers and oxidation-preventing layers may be replaced by other layers without departing from the scope of the invention. In general sense, the invention is of major importance for the manufacture of monolithic integrated circuits having a high packing density by means of conventional, $\underline{i.e.}$ non-submicron lithography.

## CLAIMS

1. A method of manufacturing a semiconductor device, in which an oxidation-preventing layer is provided on the surface of a substrate region of silicon and a masking layer is provided on this layer, after which the unmasked part of the oxidation-preventing layer is removed and an insulation region consisting at least in part of silicon oxide is formed in the exposed part of the substrate region, this insulation region surrounding an island-shaped part of the substrate region in which at least one zone of a semiconductor element is formed, and an electrode constituted by a polycrystalline silicon layer is formed on an electrode region of the semiconductor element, characterized in that, in order to form the said masking layer, a part of the oxidation-preventing layer is covered by a layer of a first material, which is then patterned and along which, without the use of a mask, an edge portion of a second material is formed, which can be etched selectively with respect to the first material and the oxidation-preventing layer, in that then the uncovered part of the oxidation-preventing layer is removed, in that subsequently the insulation region is formed at least in part in the exposed part of the substrate region, and in that the electrode region is defined by selectively etching the edge portion formed from the second material and the underlying part of the oxidation-preventing layer.

2. A method as claimed in Claim 1, characterized in that of the first and of the second material one is silicon and the other is silicon oxide.

3. A method as claimed in Claim 2, characterized in that, after the electrode region has been defined, an electrode layer of silicon is provided on the assembly, after which the said electrode layer is removed selectively above the layer of the first material and the underlying layer of the first material is then etched away selectively.

4.     A method as claimed in Claim 3, characterized in that the electrode layer of silicon is removed by planarization and etching above the layer of the first material, after which the remaining parts of the electrode layer are doped and the electrode layer is oxidized, at least one electrode region being formed by diffusion from the electrode layer.

5.     A method as claimed in Claim 4, characterized in that, after the layer of the first material has been selectively removed, at least one zone of the semiconductor element is provided in the underlying region by ion implantation, the oxidized electrode layer masking against this implantation.

6.     A method as claimed in Claim 5, characterized in that a base zone and an emitter zone of a bipolar transistor are successively implanted.

7.     A method as claimed in Claim 5 or 6, characterized in that, before a zone is implanted, the oxidation-preventing layer is removed.

8.     A method as claimed in any one of the preceding Claims, characterized in that the first material is silicon oxide and the second material is silicon.

9.     A method as claimed in Claim 8, characterized in that, after the silicon oxide layer has been provided, the assembly is covered by a layer of silicon, which is then etched back anisotropically until only the said edge portion is left.

10.     A method as claimed in any one of Claims 1 to 7, characterized in that the first material is silicon and the second material is silicon oxide, the said edge portion being formed by thermal oxidation of the first layer.

11.     A method as claimed in any one of the preceding Claims, characterized in that, after the said edge portion has been formed and the uncovered part of the oxidation-preventing layer has then been removed, the exposed silicon is etched before the insulation region is formed.

12.     A method as claimed in any one of the preceding Claims, characterized in that, before the electrode layer of silicon is oxidized, at least two connection conductors are formed therefrom.

13.        A method as claimed in Claim 11, characterized in that a groove is etched in the exposed silicon.

14.        A method as claimed in Claim 13, characterized in that the bottom and the walls of the groove are provided with a silicon oxide layer and in that the groove is then filled with polycrystalline silicon.

15.        A method as claimed in Claims 3 and 10, characterized in that the part of the electrode layer located above the layer of the first material is removed by diffusing an impurity from the layer of the first material into the electrode layer and by selective etching the doped part of the electrode layer thus obtained.

16.        A method as claimed in Claims 3 and 10, characterized in that the said edge portion is etched away only after the parts of the electrode layer located above the layer of the first material have been removed.

17.        A method as claimed in Claim 10, characterized in that, before the layer of the first material is patterned, this layer is covered by an oxidation-preventing layer.

18.        A method as claimed in Claim 6, characterized in that, before the emitter zone is implanted, a strip of a dielectric material is provided along the edge of the oxidized polycrystalline silicon layer.

19.        A semiconductor device comprising a transistor which is provided in an island-shaped part of a substrate region of silicon surrounded laterally by an insulation region in the form of a groove and having at least two zones adjoining a surface, which adjoin the groove, the groove having a width of less than 1 µm and the zones being contacted by silicon layers which adjoin the zones on contact regions bounded by the groove, whose dimension, viewed in the direction from one to the other connection, in less than 1 µm, these silicon layers being separated outside the contact regions by an insulating layer from the semiconductor surface.

20.      A semiconductor device as claimed in Claim 19, characterized in that the largest lateral dimension of the island-shaped region is at most 5 μm.

21.      A semiconductor device as claimed in Claims 19 or 20, characterized in that the transistor is a bipolar transistor and in that the zones constitute the emitter and collector zones of the transistor.

22.      A semiconductor memory manufactured by the use of the method claimed in Claim 10 comprising at least one memory cell having a substrate region of a first conductivity type, a groove laterally enclosing a part of the substrate region, a contact zone of the second opposite conductivity type located within the said part at a certain distance from the groove, a gate oxide layer covering within the said part the region located outside the contact zone, a dielectric layer covering the wall and the bottom of the groove, a good conducting filler material filling the groove, covered by an insulating layer and constituting the reference electrode, a conducting bit line adjoining the contact zone and a good conducting word line of polycrystalline silicon separated from the bit line and from the reference electrode by insulating layers and located on the gate oxide.

23.      A semiconductor memory as claimed in Claim 22, characterized in that the filler material consists of polycrystalline silicon.

24.      A semiconductor memory as claimed in Claim 22 or 23, characterized in that the dielectric layer consists of a silicon oxide layer and a layer of silicon nitride disposed thereon.

25.      A semiconductor memory as claimed in any one of Claims 22 to 24, characterized in that a channel stopper zone of the first conductivity type is provided in the bottom of the groove.

FIG.1

FIG.2

FIG.3

FIG.4

FIG.5

FIG.6

FIG.7

FIG.8

FIG.9

FIG.10

FIG.11

FIG.12A

FIG.12B

FIG.12C

FIG.13

FIG.14

FIG.15

FIG.16

FIG.17

FIG.18

FIG.19

FIG.20

FIG.21

FIG.18A

FIG.19A

FIG.21A

FIG.22

FIG.23

FIG.24

FIG.25

FIG.26

FIG.27

FIG.28

FIG.29

FIG.30

FIG.31

FIG.32

FIG.33

FIG.34

0246682

FIG.35

FIG.36

FIG.37

FIG.38

FIG.39

FIG.40

FIG.41

FIG.42

FIG.43

FIG.44

0246682

FIG.45

FIG.46

FIG.47

FIG.48

FIG.49

FIG.50

FIG.51

FIG.52

FIG.53

FIG.54

FIG.55

FIG.56

FIG.57

FIG.58

FIG.59

19 / 21

FIG.60

FIG.61

FIG.61A

FIG. 61 B

0246682

FIG.62

FIG.63

FIG.64

FIG.65

FIG.66

0246682

FIG.67

FIG.68

FIG.69

FIG 69A

European Patent Office

**EUROPEAN SEARCH REPORT**

Application number

EP 87 20 0711

## DOCUMENTS CONSIDERED TO BE RELEVANT

| Category | Citation of document with indication, where appropriate, of relevant passages | Relevant to claim | CLASSIFICATION OF THE APPLICATION (Int Cl 4) |
|---|---|---|---|
| A | IEEE JOURNAL OF SOLID-STATE CIRCUITS, vol. SC-17, no. 2, April 1982, pages 226-230, IEEE, New York, US; T. NAKAMURA et al.: "Self-aligned transistor with sidewall base electrode" * Page 227, column 2, paragraph 2 - page 228, column 1, paragraph 4; figure 3 * | 1,2 | H 01 L 21/00<br>H 01 L 21/60<br>H 01 L 21/285<br>H 01 L 21/76 |
| A | EP-A-0 036 082 (IBM) * Figures 2-14 * | 1 | |
| A | EP-A-0 083 088 (IBM) * Figures 1-7 * | 1 | |
| A | IBM TECHNICAL DISCLOSURE BULLETIN, vol. 22, no. 11, April 1980, pages 4895-4899, New York, US; N.G. ANANTHA et al.: "Self-aligned IGFET with silicon dioxide isolated source and drain" * Figures 1-9 * | 1 | **TECHNICAL FIELDS SEARCHED (Int. Cl 4)**<br><br>H 01 L |
| A | PATENT ABSTRACTS OF JAPAN; vol. 5, no. 186 (E-84)[858], 25th November 1981; & JP-A-56 111 264 (KOGYO GIJUTSUIN) 02-09-1981 | 1 | |

The present search report has been drawn up for all claims

| Place of search | Date of completion of the search | Examiner |
|---|---|---|
| THE HAGUE | 30-07-1987 | VANCRAEYNEST F.H. |